Europäisches Patentamt

European Patent Office

Office européen des brevets

(19)

(11) **EP 1 385 264 A2**

(12) **DEMANDE DE BREVET EUROPEEN**

(43) Date de publication:
**28.01.2004 Bulletin 2004/05**

(51) Int Cl.⁷: $H03F\ 3/60$

(21) Numéro de dépôt: **03291787.4**

(22) Date de dépôt: **18.07.2003**

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: **22.07.2002 FR 0209262**

(71) Demandeur: **ALCATEL
75008 Paris (FR)**

(72) Inventeurs:
• **Cavelier, Luc
06400 Cannes (FR)**
• **Aveline, Muriel
31830 Plaisance-du-Touch (FR)**
• **Voisin, Philippe
31100 Toulouse (FR)**

(74) Mandataire: **Smith, Bradford Lee et al
Compagnie Financière Alcatel,
Département de Propriété Industrielle,
5, rue Noel Pons
92734 Nanterre Cedex (FR)**

(54) **Système amplificateur pour satellite**

(57) La présente invention concerne un système amplificateur pour satellite, notamment pour systèmes amplificateurs radiofréquence incorporant des tubes amplificateurs à ondes progressives et utilisés dans les répéteurs spatiaux. Le système amplificateur (1) comporte deux modules amplificateurs ($A_1$, $A_2$) ayant chacun une entrée et une sortie, un diviseur (D) de signal ayant une entrée, une première sortie et une deuxième sortie, un combineur (C) de signal ayant une première entrée, une deuxième entrée et une sortie. La première sortie du diviseur (D) est reliée à l'entrée du premier module amplificateur ($A_1$) via une longueur de connexion $Le_1$. La deuxième sortie du diviseur (D) est reliée à l'entrée du deuxième module amplificateur ($A_2$) via une longueur de connexion $Le_2$. La sortie du premier module amplificateur ($A_1$) est reliée à la première entrée du combineur (C) via une longueur de connexion $Ls_1$. La sortie du deuxième module amplificateur ($A_2$) est reliée à la deuxième entrée dudit combineur (C) via une longueur de connexion $Ls_2$. Les longueurs de connexion vérifient la relation suivante : $Le_1 + Ls_1 = Le_2 + Ls_2$ et la longueur de connexion $Ls_1$ est différente de la longueur de connexion $Ls_2$.

**1**

Figure 1

## Description

La présente invention concerne un système amplificateur pour satellite, plus particulièrement adapté aux systèmes amplificateurs radiofréquence incorporant des tubes amplificateurs à ondes progressives et utilisés dans les répéteurs spatiaux.

Lors de la transmission de signaux par satellite, les porteuses haute fréquence provenant d'un émetteur terrestre sont reçues par le satellite à des niveaux de puissance très faibles en raison de la distance que doivent parcourir les ondes radioélectriques. Ainsi, avant de les réémettre vers la terre, le satellite doit leur redonner un niveau de puissance suffisant pour qu'un récepteur terrestre puisse les détecter. Pour ce faire, le satellite est équipé d'amplificateurs à haute puissance qui fonctionnent chacun dans une bande haute fréquence définie. L'ensemble des composants nécessaires pour amplifier les porteuses dans une gamme de fréquences donnée s'appelle un répéteur. Cet équipement se compose d'un ou plusieurs amplificateurs haute puissance et de filtres positionnés à l'entrée et à la sortie de l'amplificateur pour isoler les porteuses destinées à un répéteur donné de celles destinées à un autre répéteur. Les amplificateurs haute puissance sont généralement réalisés par des tubes à ondes progressives. Le répéteur, en plus d'amplifier les signaux reçus, les émet de nouveau sur une autre fréquence vers les stations terrestres. Nous nous limiterons seulement dans ce qui suit à la partie amplificatrice du répéteur. Par la suite, nous appellerons de façon indifférenciée, signal ou porteuse, l'information destinée à être amplifier par le répéteur.

Un tube amplificateur a une puissance maximale de l'ordre de 100W à 200W. Ainsi, pour atteindre de fortes puissances radiofréquence à bord d'un satellite, il est classique de mettre des tubes à ondes progressives en parallèle. Pour cela, on utilise des diviseurs de signaux, ces derniers étant ensuite amplifiés par les tubes puis recombinés par des coupleurs de signaux.

Toutefois, une telle utilisation peut poser certaines difficultés.

Ainsi, le signal divisé va parcourir deux trajets distincts et la recombinaison des signaux divisés et amplifiés en sortie ne sera efficace que si ceux-ci sont parfaitement en phase, la phase étant directement liée à la distance parcourue par le signal.

En effet, la somme de deux signaux S1 de puissance P1 et S2 de puissance P2 de forme d'onde identique et déphasés de $\Delta\varphi$ est un signal S de puissance P tel que :

$$P = \frac{P_1 + P_2}{2} + \sqrt{P_1 P_2} \cos\Delta\varphi$$

En conséquence, plus le déphasage est élevé plus la puissance P est faible et moins la mise en parallèle de tubes est efficace.

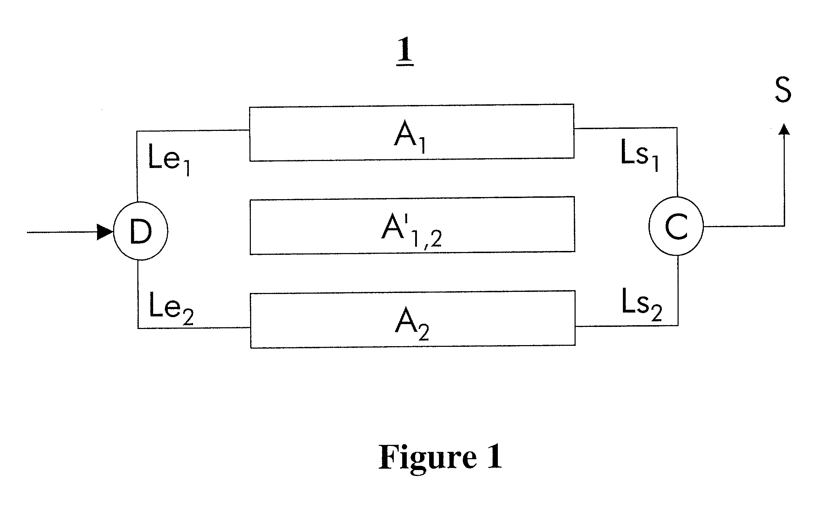

Une solution à ces difficultés est montrée en figure 1. La configuration de la figure 1 montre ainsi un système amplificateur 1 comportant :

- trois tubes amplificateurs $A_1$, $A_2$ et $A'_{1,2}$,
- un diviseur de signal D ayant une entrée, une première sortie et une deuxième sortie,
- un coupleur de signal C ayant une première entrée, une deuxième entrée et une sortie,

La première sortie du diviseur D est reliée à l'entrée du premier tube amplificateur $A_1$ via une longueur de connexion $Le_1$.

La deuxième sortie du diviseur D est reliée à l'entrée du deuxième tube amplificateur $A_2$ via une longueur de connexion $Le_2$.

La sortie du tube amplificateur $A_1$ est reliée à la première entrée du combineur C via une longueur de connexion $Ls_1$.

La sortie du deuxième tube amplificateur $A_2$ est reliée à la deuxième entrée du combineur C via une longueur de connexion $Ls_2$.

La sortie du combineur est ensuite reliée à la sortie S du répéteur via une longueur L de connexion.

Le tube amplificateur $A'_{1,2}$ est un tube redondant non actif utile uniquement en cas de panne d'un des tubes $A_1$ ou $A_2$.

Généralement les connexions en amont d'un amplificateur sont réalisées à l'aide de câbles coaxiaux alors que les connexions en aval d'un amplificateur sont réalisées à l'aide de guides d'ondes, les signaux étant de plus forte puissance.

Cette configuration est totalement symétrique en entrée et en sortie, c'est à dire que les longueurs de connexion sont toutes égales. Ceci permet de n'introduire aucun déphasage entre les signaux divisés puis recombinés.

Toutefois, la mise en oeuvre d'une telle configuration pose certaines difficultés.

En effet, la symétrie du montage impose des contraintes géométriques sur le routage du harnais de la section de sortie et une forte consommation de guides d'ondes. Ainsi, la sortie du répéteur étant fixe. Les contraintes géométriques dues à la symétrie du système amplificateur imposent d'utiliser une grande longueur de guide d'onde pour se connecter à la sortie. Cette utilisation importante de guides d'ondes en sortie provoque des pertes ohmiques. Ces pertes sont d'autant plus fortes que la fréquence est élevée.

En outre, l'utilisation accrue de guides d'onde entraîne une augmentation du coût et de la masse totale du répéteur.

La présente invention vise à fournir un système amplificateur pour satellite permettant de limiter les pertes ohmiques, le coût et l'augmentation de la masse totale du répéteur tout en maintenant le phasage des signaux.

La présente invention propose à cet effet un système amplificateur pour satellite comportant

- un premier et un deuxième module amplificateur ayant chacun une entrée et une sortie,
- un diviseur de signal ayant une entrée, une première sortie et une deuxième sortie,
- un combineur de signal ayant une première entrée, une deuxième entrée et une sortie,

ladite première sortie dudit diviseur étant reliée à ladite entrée dudit premier module amplificateur via une longueur de connexion $Le_1$,
ladite deuxième sortie dudit diviseur étant reliée à ladite entrée dudit deuxième module amplificateur via une longueur de connexion $Le_2$,
ladite sortie dudit premier module amplificateur étant reliée à ladite première entrée dudit combineur via une longueur de connexion $Ls_1$,
ladite sortie dudit deuxième module amplificateur étant reliée à ladite deuxième entrée dudit combineur via une longueur de connexion $Ls_2$,
lesdites longueurs de connexion vérifiant la relation suivante :

$$Le_1 + Ls_1 = Le_2 + Ls_2,$$

ledit système étant **caractérisé en ce que** la longueur de connexion $Ls_1$ est différente de la longueur de connexion $Ls_2$.

Grâce à l'invention, les connexions, généralement des guides d'ondes, après l'étage amplificateur ne sont plus de longueurs égales ce qui permet de concevoir ces connexions au plus court pour atteindre la sortie et de faciliter ainsi l'aménagement de ces connexions. La diminution de la longueur des connexions va entraîner une diminution des pertes ohmiques et de la masse totale du système. Le phasage des signaux entre l'entrée et la sortie du système est cependant respecté grâce à la relation $Le_1 + Ls_1 = Le_2 + Ls_2$ qui permet aux signaux de parcourir la même longueur de connexion de bout en bout. De plus, à longueur de connexion égale, le système selon l'invention offre une meilleure performance en puissance et donc la possibilité de diminuer la puissance d'amplification.

Avantageusement, la longueur $Le_1$ est égale à la longueur $Ls_2$ et la longueur $Le_2$ est égale à la longueur $Ls_1$.

Selon un mode de réalisation, l'un au moins desdits modules amplificateurs est un tube amplificateur à ondes progressives ou un amplificateur à semiconducteur SSPA (Solid State Power Amplifier).

Avantageusement, les connexions entre les sorties desdits modules amplificateurs et l'entrée dudit combineur sont des guides d'ondes.

Selon un mode de réalisation avantageux, l'un au moins desdits modules amplificateurs comporte :

- un premier et un deuxième sous-module amplificateur ayant chacun une entrée et une sortie,
- un diviseur de signal ayant une entrée, une première sortie et une deuxième sortie,
- un combineur de signal ayant une première entrée, une deuxième entrée et une sortie,

ladite première sortie dudit diviseur étant reliée à ladite entrée dudit premier sous-module amplificateur via une longueur de connexion $Le_{11}$,
ladite deuxième sortie dudit diviseur étant reliée à ladite entrée dudit deuxième sous-module amplificateur via une longueur de connexion $Le_{12}$,
ladite sortie dudit premier sous-module amplificateur étant reliée à ladite première entrée dudit combineur via une longueur de connexion $Ls_{11}$,
ladite sortie dudit deuxième sous-module amplificateur étant reliée à ladite deuxième entrée dudit combineur via une longueur de connexion $Ls_{12}$,
lesdites longueurs de connexion vérifiant la relation suivante : $Le_{11} + Ls_{11} = Le_{12} + Ls_{12}$ et la longueur de connexion $Ls_{11}$ étant différente de la longueur de connexion $Ls_{12}$.

Ainsi, le système amplificateur selon l'invention comprend des modules amplificateurs qui sont soit des tubes amplificateurs uniques soit un ensemble de tubes en parallèle permettant d'assurer l'amplification. Ledit module peut alors être lui-même assimilé à un système amplificateur selon l'invention avec un aménagement de ses connexions de sortie.

D'autres caractéristiques et avantages de la présente invention apparaîtront dans la description suivante d'un mode de réalisation donnée à titre illustratif et nullement limitatif.

Dans les figures suivantes :

• La figure 1 représente un système amplificateur selon l'art antérieur,
• La figure 2 représente un système amplificateur selon l'invention comportant trois tubes en parallèle,
• La figure 3 représente un système amplificateur selon l'invention comportant six tubes en parallèle.

Dans toutes les figures, les éléments communs portent les mêmes numéros de références.

La figure 1 a déjà été décrite en relation avec l'état de la technique.

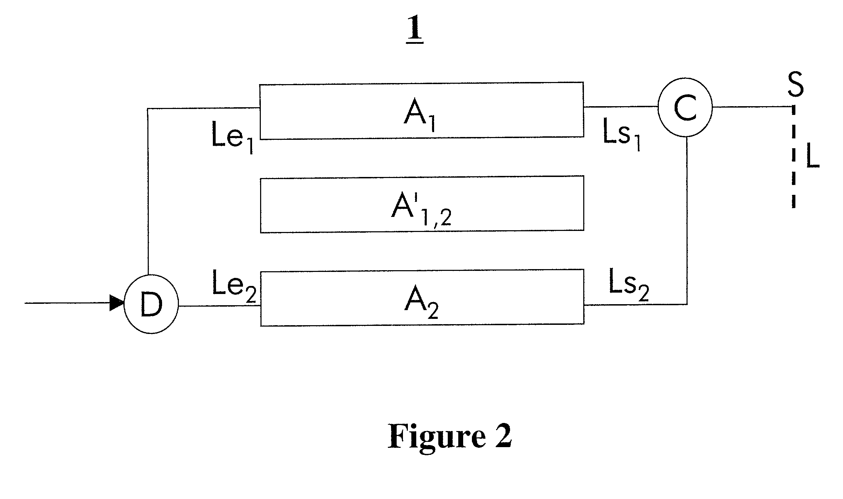

La figure 2 présente un système amplificateur 1 selon l'invention.

Le système 1 comporte :

- trois tubes amplificateurs $A_1$, $A_2$ et $A'_{1,2}$,
- un diviseur de signal D ayant une entrée, une première sortie et une deuxième sortie,

- un coupleur de signal C ayant une première entrée, une deuxième entrée et une sortie,

La première sortie du diviseur D est reliée à l'entrée du premier tube amplificateur $A_1$ via une longueur de connexion $Le_1$.

La deuxième sortie du diviseur D est reliée à l'entrée du deuxième tube amplificateur $A_2$ via une longueur de connexion $Le_2$.

La sortie du tube amplificateur $A_1$ est reliée à la première entrée du combineur C via une longueur de connexion $Ls_1$.

La sortie du deuxième tube amplificateur $A_2$ est reliée à la deuxième entrée du combineur C via une longueur de connexion $Ls_2$.

Le tube amplificateur $A'_{1,2}$ est un tube redondant non actif utile uniquement en cas de panne d'un des tubes $A_1$ ou $A_2$.

Les connexions de longueurs $Le_1$ et $Le_2$ sont réalisées en câbles coaxiaux alors que les connexions de longueurs $Ls_1$ et $Ls_2$ sont réalisées à l'aide de guides d'ondes.

Les longueurs de connexion vérifient la relation suivante :

$Le_1 + Ls_1 = Le_2 + Ls_2$, ce qui permet aux signaux divisés puis recombinés de rester en phase puisqu'ils parcourent tous le même chemin entre l'entrée et la sortie du système 1.

La longueur $Ls_1$ est différente de la longueur $Ls_2$, ce qui permet de rapprocher le combineur C de la sortie S.

Selon ce mode de réalisation, la longueur $Le_1$ est égale à la longueur $Ls_2$ et la longueur $Le_2$ est égale à la longueur $Ls_1$. On peut cependant choisir une longueur $Le_1$ différente de la longueur $Ls_2$ et une longueur $Le_2$ différente de la longueur $Ls_1$ tout en maintenant l'égalité $Le_1 + Ls_1 = Le_2 + Ls_2$.

En comparaison du système amplificateur représenté en figure 1, le système selon l'invention permet de gagner une longueur L de guide d'ondes sensiblement égale au pas d'implantation des tubes égal à environ 0,15 m.

Les pertes ohmiques en bande Ka à une fréquence de 20 GHz sont comprises entre 0,25 et 0,4 dB/ m. Le système 1 permet donc un gain compris entre 0,0375 et 0,06 dB.

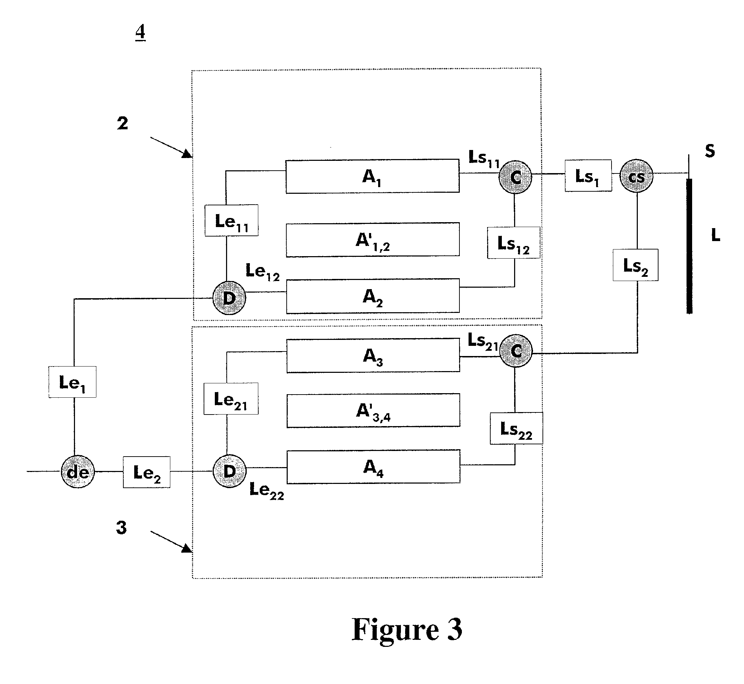

La figure 3 représente un système amplificateur 4 selon l'invention.

Le système 4 comporte

- deux modules amplificateurs 2 et 3,
- un diviseur de signal $d_e$ d'entrée ayant une entrée, une première sortie et une deuxième sortie,
- un coupleur de signal $c_s$ ayant une première entrée, une deuxième entrée et une sortie,

La première sortie du diviseur $d_e$ est reliée à l'entrée du premier module amplificateur 2 via une longueur de connexion $Le_1$.

La deuxième sortie du diviseur $d_e$ est reliée à l'entrée du deuxième module amplificateur 3 via une longueur de connexion $Le_2$.

La sortie du premier module amplificateur 2 est reliée à la première entrée du combineur $c_s$ via une longueur de connexion $Ls_1$.

La sortie du deuxième module amplificateur 4 est reliée à la deuxième entrée du combineur $c_s$ via une longueur de connexion $Ls_2$.

Généralement, les connexions de longueurs $Le_1$ et $Le_2$ sont réalisées en câbles coaxiaux alors que les connexions de longueurs $Ls_1$ et $Ls_2$ sont réalisées à l'aide de guides d'ondes.

Les longueurs de connexion vérifient la relation suivante :

$$Le_1 + Ls_1 = Le_2 + Ls_2.$$

La longueur $Ls_1$ est différente de la longueur $Ls_2$.

Les modules amplificateurs 2 et 3 sont chacun des systèmes amplificateurs identiques à celui décrit conformément à la figure 2 pour lesquels les longueurs $Le_{11}$, $Le_{12}$, $Ls_{11}$ et $Ls_{12}$ correspondent au module 2 et les longueurs $Le_{21}$, $Le_{22}$, $Ls_{21}$ et $Ls_{22}$ correspondent au module 3. Le module 2 comporte trois tubes amplificateurs $A_1$, $A_2$ et $A'_{1,2}$ et le module 3 comporte trois tubes amplificateurs $A_3$, $A_4$ et $A'_{3,4}$. L'un de ces modules 2 ou 3 pourrait également être un tube amplificateur seul.

Le combineur $c_s$ est ainsi rapproché au plus près de la sortie S.

En comparaison d'un système amplificateur totalement symétrique, le système 4 selon l'invention permet de gagner une longueur L de guide d'ondes sensiblement égale à 2,5x0,15 m, soit 0,375 m. Le système 4 permet donc un gain compris entre 0,094 et 0,15 dB.

En généralisant à n tubes amplificateurs en parallèle, l'invention permet de gagner au maximum une longueur $\frac{n-1}{2} \times 0.15$ m, où n représente le nombre de tubes installés et 0,15 m le pas d'implantation des tubes.

Bien entendu, l'invention n'est pas limitée aux modes de réalisation qui viennent d'être décrit.

Notamment, les deux modes de réalisation décrits portent sur 3 tubes (dont un redondant) et 6 tubes (dont 2 redondants) mis en parallèle. L'invention peut être généralisée à n tubes en parallèle en définissant de façon récurrente chaque module amplificateur comme un système amplificateur selon l'invention.

En outre, les modes de réalisation ont été décrits avec des tubes amplificateurs redondants qui peuvent être supprimés.

De plus, les modes de réalisation ont été décrits avec des tubes amplificateurs qui peuvent être remplacés par des amplificateurs à semiconducteur du type SSPA (Solid State Power Amplifier).

De même, les connexions entre les sorties des modules amplificateurs et l'entrée du combineur ont été décrites comme des guides d'ondes mais elles peuvent également être réalisées en en câbles coaxiaux.

**Revendications**

1. Système amplificateur (1) pour satellite comportant

   - un premier et un deuxième module amplificateur (A$_1$, A$_2$) ayant chacun une entrée et une sortie,
   - un diviseur (D) de signal ayant une entrée, une première sortie et une deuxième sortie,
   - un combineur (C) de signal ayant une première entrée, une deuxième entrée et une sortie,

   ladite première sortie dudit diviseur (D) étant reliée à ladite entrée dudit premier module amplificateur (A$_1$) via une longueur de connexion Le$_1$,
   ladite deuxième sortie dudit diviseur (D) étant reliée à ladite entrée dudit deuxième module amplificateur (A$_2$) via une longueur de connexion Le$_2$,
   ladite sortie dudit premier module amplificateur (A$_1$) étant reliée à ladite première entrée dudit combineur (C) via une longueur de connexion Ls$_1$,
   ladite sortie dudit deuxième module amplificateur (A$_2$) étant reliée à ladite deuxième entrée dudit combineur (C) via une longueur de connexion Ls$_2$,
   lesdites longueurs de connexion vérifiant la relation suivante : Le$_1$ + Ls$_1$ = Le$_2$ + Ls$_2$,
   ledit système étant **caractérisé en ce que** la longueur de connexion Ls$_1$ est différente de la longueur de connexion Ls$_2$.

2. Système amplificateur (1) pour satellite selon la revendication 1 **caractérisé en ce que** ladite longueur Le$_1$ est égale à ladite longueur Ls$_2$ et ladite longueur Le$_2$ est égale à ladite longueur Ls$_1$.

3. Système amplificateur (1) pour satellite selon l'une des revendications 1 ou 2 **caractérisé en ce que** l'un au moins desdits modules amplificateurs (A$_1$, A$_2$) est un tube amplificateur à ondes progressives.

4. Système amplificateur (1) pour satellite selon l'une des revendications 1 ou 2 **caractérisé en ce que** l'un au moins desdits modules amplificateurs est un amplificateur à semiconducteur SSPA.

5. Système amplificateur (1) pour satellite selon l'une des revendications 1 à 4 **caractérisé en ce que** les connexions entre les sorties desdits modules amplificateurs et l'entrée dudit combineur sont des guides d'ondes.

6. Système amplificateur (1) pour satellite selon l'une des revendications 1 à 5 **caractérisé en ce que** l'un au moins desdits modules amplificateurs (2) comporte

   - un premier et un deuxième sous-module amplificateur (A$_1$, A$_2$) ayant chacun une entrée et une sortie,
   - un diviseur (d) de signal ayant une entrée, une première sortie et une deuxième sortie,
   - un combineur (c) de signal ayant une première entrée, une deuxième entrée et une sortie,

   ladite première sortie dudit diviseur (d) étant reliée à ladite entrée dudit premier sous-module amplificateur (A$_1$) via une longueur de connexion Le$_{11}$,
   ladite deuxième sortie dudit diviseur (d) étant reliée à ladite entrée dudit deuxième sous-module amplificateur (A$_2$) via une longueur de connexion Le$_{12}$,
   ladite sortie dudit premier sous- module amplificateur (A$_2$) étant reliée à ladite première entrée dudit combineur via une longueur de connexion Ls$_{11}$,
   ladite sortie dudit deuxième sous-module amplificateur étant reliée à ladite deuxième entrée dudit combineur via une longueur de connexion Ls$_{12}$,
   lesdites longueurs de connexion vérifiant la relation suivante : Le$_{11}$ + Ls$_{11}$ = Le$_{12}$ + Ls$_{12}$ et la longueur de connexion Ls$_{11}$ étant différente de la longueur de connexion Ls$_{12}$.

Figure 1

**Figure 2**

EP 1 385 264 A2

Figure 3

EP 1 385 264 A2